# EUROPEAN PATENT APPLICATION

(11) **EP 0 712 006 A2**
(43) Date of publication of application: **15.05.1996**
(21) Application number: 95117096.8
(22) Date of filing: 30.10.1995
(51) Int. Cl.: G01R 31/28

(54) **Apparatus and method for identifying the source of an electric field**

(30) Priority: 11.11.1994 IL 11159994
(71) Applicant: STATE OF ISRAEL MINISTRY OF DEFENCE RAFAEL ARMAMENT DEVELOPMENT AUTHORITY, Haifa 31 021 (IL)
(72) Inventor: Hartal, Oren, 36066 Kiryat Tivon (IL)
(74) Representative: Wallinger, Michael, Dr.-Ing.

(57) **Abstract**

An apparatus for identifying the source of an electric field in the vicinity of electronic equipment under test. The apparatus includes a receiver for measuring the amplitude of signals, a first antenna deployed at a first distance from the electronic equipment for providing a first signal to the receiver and a second antenna deployed at a second distance from the electronic equipment for providing a second signal to the receiver, the second distance being substantially greater than the first distance. The apparatus further includes a switch having a normally closed position connecting the receiver to the first antenna and a normally open position connecting the receiver to the second antenna. Finally, the apparatus includes a controller for controlling the switch such that the receiver is connected to the second antenna when the amplitude of the first signal at a given frequency is greater than a pre-determined level for the given frequency and a comparator for comparing the amplitude of the second signal at the given frequency to the amplitude of the first signal at the given frequency so as to enable the identification of the source of the electric field as being the electronic equipment when the amplitude of the second signal at the given frequency is substantially less than to the amplitude of the first signal at the given frequency.

## Description

### FIELD AND BACKGROUND OF THE INVENTION

The present invention relates to apparatus and methods for identifying the source of an electric field in the vicinity of electronic equipment in general and in particular for open-site EMI measurement of the electronic equipment.

Currently, apparatus for open-site EMI measurement of electronic equipment includes an antenna for deployment in the vicinity of electronic equipment under test and a receiver connected to the antenna for measuring the amplitude of the electric field in the vicinity of the electronic equipment at frequencies over a band width of 30 MHz to 1000 MHz.

The method for open-site EMI measurement of electronic equipment using this apparatus is as follows: An operator switches on the electronic equipment and compares the amplitude of the signal measured at each frequency to a pre-determined limit. If the amplitude of a signal measured at a particular frequency is greater than the pre-determined limit for that frequency, then the operator has to identify the source of the signal as being either the electric field emitted by the electronic equipment or background noise. This is achieved by the operator switching off the electronic equipment and measuring the amplitude of the signal again at the same frequency. If the amplitude of the signal is largely unchanged, then the source of the signal is background noise. Alternately, if the amplitude of the signal decreases appreciably, then the source of the signal is the electric field emitted by the electronic equipment. In this case, the operator switches the electronic equipment back on again and then records the amplitude of the signal for that frequency.

It can therefore be readily appreciated that the current procedure for identifying the source of an electric field in the vicinity of electronic equipment under test - and therefore the open-site EMI measurement of the electronic equipment - is both time consuming and troublesome due to the need to switch the electronic equipment under test off and on a number of times.

There is therefore a need for apparatus and method for identifying the source of an electric field in the vicinity of electronic equipment under test for use in open-site EMI measurement of the electronic equipment.

### SUMMARY OF THE INVENTION

The present invention is for apparatus and method for identifying the source of an electric field in the vicinity of electronic equipment under test for use in open-site EMI measurement of the electronic equipment.

Hence, there is provided according to the teachings of the present invention, apparatus for identifying the source of an electric field in the vicinity of electronic equipment under test, the apparatus comprising: (a) a receiver for measuring the amplitude of signals; (b) a first antenna deployed at a first distance from the electronic equipment for providing a first signal to the receiver; (c) a second antenna deployed at a second distance from the electronic equipment for providing a second signal to the receiver, the second distance being substantially greater than the first distance; (d) a switch having a normally closed position connecting the receiver to the first antenna and a normally open position connecting the receiver to the second antenna; (e) a controller for controlling the switch such that the receiver is connected to the second antenna when the amplitude of the first signal at a given frequency is greater than a pre-determined level for the given frequency; and (f) a comparator for comparing the amplitude of the second signal at the given frequency to the amplitude of the first signal at the given frequency so as to enable the identification of the source of the electric field as being the electronic equipment when the amplitude of the second signal at the given frequency is substantially less than the amplitude of the first signal at the given frequency.

According to a further feature of the present invention, the apparatus further comprising a recorder for recording the amplitude of the first signal at the given frequency when the amplitude of the second signal at the given frequency is substantially less than to the amplitude of the first signal at the given frequency so as to enable EMI measurement of the electronic equipment.

According to a still further feature of the present invention, the receiver receives the signals within a band width of between about 30 MHz and about 1000 MHz.

According to a yet still further feature of the present invention, the first distance is between about 1 m and about 5 m from the electronic equipment.

According to a yet still further feature of the present invention, the second distance is between about 8 m and about 30 m from the electronic equipment.

There is also provided according to the teachings of the present invention, a method for identifying the source of an electric field in the vicinity of electronic equipment under test, the method comprising the steps of: (a) receiving a first signal from a first antenna deployed at a first distance from the electronic equipment; (b) receiving a second signal from a second antenna deployed at a second distance from the electronic equipment, the second distance being substantially greater than the first distance; (c) measuring the amplitude of the second signal when the amplitude of the first signal at a given frequency is greater than a pre-determined limit for the given frequency; and (d) comparing the amplitude of the second signal at the given frequency to the amplitude of the first signal at the given frequency so as to enable the identification of the source of the electric field as being the electronic equipment when the amplitude of the second signal at the given frequency is substantially less than the amplitude of the first signal at the given frequency.

According to a further feature of the present invention, the method further comprising the step of recording the amplitude of the first signal at the given frequency when the amplitude of the second signal at the given frequency is substantially less than to the amplitude of the first signal at the given frequency so as to enable EMI measurement of the electronic equipment.

According to a still further feature of the present invention, the signals are received within a band width of between about 30 MHz and about 1000 MHz.

According to a yet still further feature of the present invention, the first distance is between about 1 m and about 5 m from the electronic equipment.

According to a yet still further feature of the present invention, the second distance is between about 8 m and about 30 m from the electronic equipment.

### BRIEF DESCRIPTION OF THE DRAWINGS

The invention is herein described, by way of example only, with reference to the accompanying drawings, wherein:
FIG. 1 is a schematic illustration not drawn to scale of apparatus for identifying the source of an electric field in the vicinity of electronic equipment under test for use in open-site EMI measurement of the electronic equipment according to the teachings of the present invention; and
FIG. 2 is a flow diagram of a method for identifying the source of an electric field in the vicinity of electronic equipment under test for use in open-site EMI measurement of the electronic equipment according to the teachings of the present invention using the apparatus of Figure 1.

### DESCRIPTION OF THE PREFERRED EMBODIMENTS

The present invention is of apparatus and method for identifying the source of an electric field in the vicinity of electronic equipment under test for use in open-site EMI measurement of the electronic equipment.

The principles and operation of the apparatus and method according to the present invention may be better understood with reference to the drawings and the accompanying description.

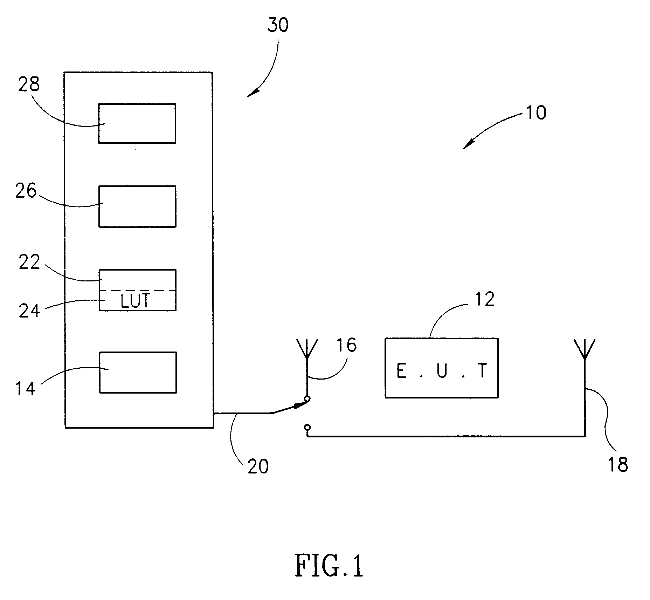

Referring now to the drawings, Figure 1 shows an apparatus, generally designated **10**, constructed and operative according to the teachings of the present invention, for identifying the source of an electric field in the vicinity of electronic equipment under test **12** for use in open-site EMI measurement of electronic equipment **12**. Generally speaking, apparatus **10** takes advantage of the fact that, on the one hand, a receiver connected to two spaced apart antennas will measure a substantially similar amplitude from each antenna for background noise while, on the other hand, the receiver will measure substantially different amplitudes for an electric field originating from electronic equipment deployed closer to one antenna than the other antenna.

Hence, apparatus **10** includes a receiver **14** for measuring the amplitude of signals received from either a main antenna **16** deployed proximate to electronic equipment **12** or an auxiliary antenna **18** deployed remote to electronic equipment **12**. It should be noted that the terms "proximate" and "remote" in the present context indicate that main antenna **16** is deployed substantially closer to electronic equipment **12** than auxiliary antenna **18**. Typically, main antenna **16** is between about 1 m and about 5 m from electronic equipment **12** while auxiliary antenna **18** is between about 8 m and about 30 m therefrom. Receiver **14** preferably scans frequencies within a band width of between about 30 MHz and about 1000 MHz.

Connection between receiver **14** and either antenna **16** or antenna **18** is determined by a switch **20** under the control of a controller **22**. Switch **20** has a normally closed position for connecting receiver **14** to main antenna **16** and a normally open position for connecting receiver **14** to auxiliary antenna **18**. Controller **22** controls switch **20** such that receiver **12** is connected to auxiliary antenna **18** when the amplitude of a signal from main antenna **16** at a particular frequency is greater than a pre-determined limit for that frequency according to a Look-Up-Table (LUT) **24** of amplitude against frequency stored in controller **22**.

Apparatus **10** also includes a comparator **26** for comparing the amplitude of a signal from main antenna **16** to the amplitude of a signal from auxiliary antenna **18** at a given frequency to enable the identification of the source of an electric field in the vicinity of electronic equipment **12**. When the amplitude of the signal from main antenna **16** is substantially greater than the amplitude of the signal from auxiliary antenna **18**, then comparator **26** indicates that the source of the electric field is electronic equipment **12**. In contrast, when the amplitude of the signal from main antenna **16** is substantially similar to the amplitude of the signal from auxiliary antenna **18**, then comparator **26** indicates that the source of the electric field is background noise.

Apparatus **10** further includes a recorder **28** for recording the amplitude of signals. Recorder **28** preferably records the amplitude of a signal from main antenna **16** at a given frequency when two conditions apply. First, the amplitude of the signal at that frequency from main antenna **16** is greater than a pre-determined limit for that frequency as stored in LUT **24**. And second, the amplitude at that frequency from auxiliary antenna **18** is substantially less than the amplitude of the signal from main antenna **16** at that frequency.

Controller **22**, LUT **24**, comparator **26** and recorder **28** are preferably implemented as a single computerized module generally designated **30**. Furthermore, it should be noted that preferably both controller **24** and comparator **26** take into account the antenna factors of main antenna **16** and auxiliary antenna **18** when comparing amplitudes of signals.

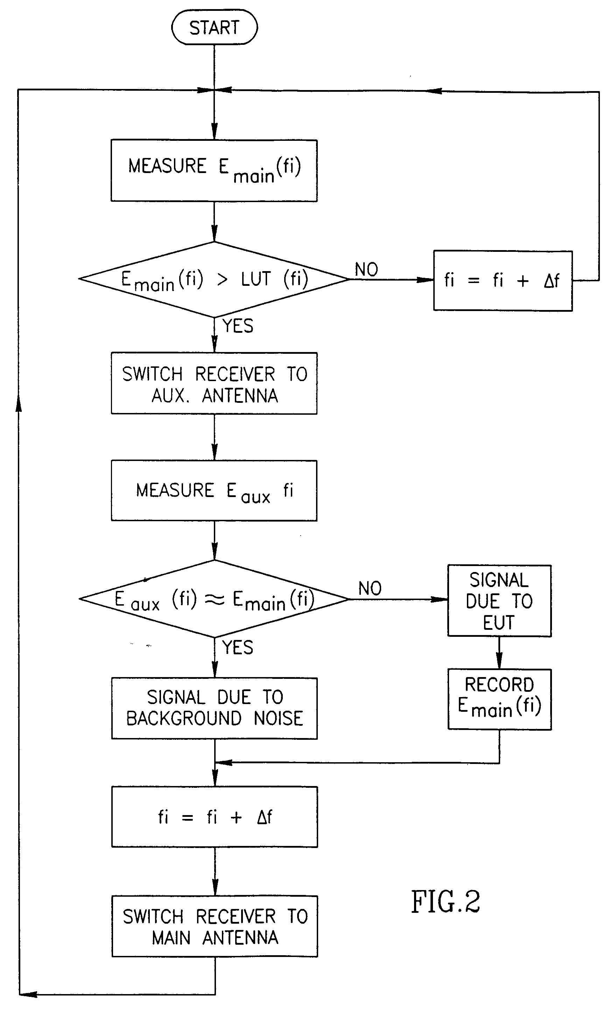

With reference now to Figure 2, the method for identifying the source of an electric field in the vicinity of electronic equipment under test **12** for use in open-site EMI measurement of electronic equipment **12** is achieved using apparatus **10** is now described. Apparatus **10** is set-up such that one of antennas **16** and **18** is deployed substantially closer to electronic equipment **12** than the other antenna. In this case, main antenna **16** is deployed 3 m from electronic equipment **12** while auxiliary antenna **18** is deployed 30 m therefrom. Switch **20** is set by controller **22** such that receiver **14** is connected to measure signals from antenna **16**. Receiver **14** begins to scan frequencies from about 30 MHz to about 1000 MHz.

Controller **22** compares the amplitude of the signal at each frequency to a pre-determined limit stored in LUT **24**. If the amplitude of a signal at a particular frequency is greater than the pre-determined limit for that frequency, then apparatus **10** has to identify the source of the signal between either the electric field emitted by electronic equipment **12** or background noise. This is achieved by controller **22** controlling switch **20** such that receiver **14** is connected to auxiliary antenna **18** instead of main antenna **16**. Comparator **26** identifies the source of the electric field by comparing the amplitude of the signal from auxiliary antenna **18** to the amplitude of the signal from main antenna **16** at the same frequency according to the following rules: If the amplitudes of the signals from main antenna **16** and auxiliary antenna **18** are substantially similar, then the source of the signal is background noise because both antennas **16** and **18** provide similar signals for background noise by virtue of them being the same distance from the background source. Alternately, if the amplitude of the signal from auxiliary antenna **18** is substantially less than the amplitude of the signal from main antenna **16**, then the source of the signal is the electric field emitted by electronic equipment **12** because main antenna **16** provides a stronger signal than auxiliary antenna **18** for the electric field emitted by electronic equipment **12** due to its closer proximity thereto. In this case, recorder **28** records the amplitude of the signal from main antenna **16** at that frequency.

All in all, it can be readily appreciated that apparatus **10** enables open-site EMI measurement of electronic equipment **12** without the time consuming and bothersome task of having to shut-off electronic equipment **12** to determine the source of the electric field for each signal having an amplitude greater than a pre-determined limit.

While the invention has been described with respect to a limited number of embodiments, it will be appreciated that many variations, modifications and other applications of the invention may be made.

## Claims

1. Apparatus for identifying the source of an electric field in the vicinity of electronic equipment under test, the apparatus comprising:
(a) a receiver for measuring the amplitude of signals;
(b) a first antenna deployed at a first distance from the electronic equipment for providing a first signal to said receiver;
(c) a second antenna deployed at a second distance from the electronic equipment for providing a second signal to said receiver, said second distance being substantially greater than said first distance;
(d) a switch having a normally closed position connecting said receiver to said first antenna and a normally open position connecting said receiver to said second antenna;
(e) a controller for controlling said switch such that said receiver is connected to said second antenna when the amplitude of said first signal at a given frequency is greater than a pre-determined level for said given frequency; and
(f) a comparator for comparing the amplitude of said second signal at said given frequency to the amplitude of said first signal at said given frequency so as to enable the identification of the source of the electric field as being the electronic equipment when the amplitude of said second signal at said given frequency is substantially less than to the amplitude of said first signal at said given frequency.

2. The apparatus as in claim 1, further comprising a recorder for recording the amplitude of said first signal at said given frequency when the amplitude of said second signal at said given frequency is substantially less than the amplitude of said first signal at said given frequency so as to enable EMI measurement of the electronic equipment.

3. The apparatus as in claim 1, when said receiver receives said signals within a band of between about 30 MHz and about 1000 MHz.

4. The apparatus as in claim 1, wherein said first distance is between about 1 m and about 5 m from the electronic equipment.

5. The apparatus as in claim 1, wherein said second distance is between about 8 m and about 30 m from the electronic equipment.

6. A method for identifying the source of an electric field in the vicinity of electronic equipment under test, the method comprising the steps of:
(a) receiving a first signal from a first antenna deployed at a first distance from the electronic equipment;
(b) receiving a second signal from a second antenna deployed at a second distance from the electronic equipment, the second distance being substantially greater than the first distance;
(c) measuring the amplitude of the second signal when the amplitude of the first signal at a given frequency is greater than a pre-determined limit for the given frequency; and
(d) comparing the amplitude of the second signal at the given frequency to the amplitude of the first signal at the given frequency so as to enable the identification of the source of the electric field as being the electronic equipment when the amplitude of the second signal at the given frequency is substantially less than the amplitude of the first signal at the given frequency.

7. The method as in claim 6, further comprising the step of recording the amplitude of the first signal at the given frequency when the amplitude of the second signal at the given frequency is substantially less than the amplitude of the first signal at the given frequency so as to enable EMI measurement of the electronic equipment.

8. The method as in claim 6, when signals are received within a band of between about 30 MHz and about 1000 MHz.

9. The method as in claim 6, wherein the first distance is between about 1 m and about 5 m from the electronic equipment.

10. The method as in claim 6, wherein the second distance is between about 8 m and about 30 m from the electronic equipment.
